# EUROPÄISCHE PATENTSCHRIFT

(11) **EP 2 956 894 B1**
(45) Veröffentlichungstag und Bekanntmachung des Hinweises auf die Patenterteilung: **29.03.2017**
(21) Anmeldenummer: 14704573.6
(22) Anmeldetag: 13.02.2014
(51) Int. Cl.: G06K 19/077, G06K 19/02

(54) **VERFAHREN ZUR HERSTELLUNG EINER PAPIERTRÄGERKARTE MIT HERAUSTRENNBARER INTEGRIERTER CHIPMODULKARTE UND PAPIERTRÄGERKARTE AUS PAPIER MIT HERAUSTRENNBARER INTEGRIERTER CHIPMODULKARTE**
METHOD FOR THE PRODUCTION OF A CARD MADE OUT OF PAPER WITH SEPARABLE INTEGRATED CHIP MODULE CARD AND CARD MADE OUT OF PAPER WITH SEPARABLE INTEGRATED CHIP CARD MODULE
METHODE POUR LA PRODUCTION D'UNE CARTE DE PAPIER AVEC MODULE CARTE A PUCE INTEGRE ET SEPARABLE ET CARTE DE PAPIER AVEC MODULE CARTE A PUCE INTEGRE ET SEPARABLE

(30) Priorität: 14.02.2013 DE 102013002536
(43) Veröffentlichungstag der Anmeldung: 23.12.2015
(73) Patentinhaber: Mühlbauer GmbH & Co. KG, 93426 Roding (DE); OSCARDS AG, 8330 Pfaeffikon (CH)
(72) Erfinder: GOETZ, Emil, CH-8952 Schlieren (CH); VASIC, Milenko, CH-8954 Geroldsund (CH); STEIF, Richard, 93489 Schorndorf (DE); LANKES, Guenter, 93413 Cham (DE)
(74) Vertreter: Schmidt, Steffen J.
(86) Internationale Anmeldenummer: PCT/EP2014/052834
(87) Internationale Veröffentlichungsnummer: WO 2014/125031

(56) Entgegenhaltungen:
- EP-A1- 1 405 260
- EP-A1- 2 423 857
- WO-A2-03/056499

## Beschreibung

### Hintergrund

Hier wird ein Verfahren zur Herstellung einer Papierträgerkarte mit heraustrennbarer integrierter Chipmodulkarte, zum Beispiel in Form einer SIM-Karte oder dergleichen, mit einem ein- oder mehrschichtigen Körper beschrieben. Des Weiteren wird eine Papierträgerkarte aus Papier mit einem heraus-trennbarer integrierter Chipmodulkarte beschrieben. Integrierte Chipmodulkarten oder SIM-Karten (**s**ubscriber identity **m**odule "Teilnehmer-Identitätsmodul") können unterschiedliche Abmessungen haben: "Full-size" siehe ISO/IEC 7810:2003, *ID-1 "Mini-SIM"* siehe ISO/IEC 7810:2003, *ID-000,* "Micro-SIM" siehe ETSI TS 102 221 V9.0.0 = "Mini-UICC", "Nano-SIM" siehe ETSI TS 102 221, TS 102 221 V11.0.0, und "Embedded-SIM" siehe JEDEC Design Guide 4.8.

Üblicherweise werden SIM-Kartenhalter aus Plastik produziert, die als Transporthalterungen für die SIM-Karten für Mobiltelefone dienen. Zum Gebrauch werden die SIM-Karten aus der Transporthalterung herausgelöst und in das Mobiltelephon eingesetzt. Der Rest des SIM-Kartenhalters, also die Transporthalterung, wird entsorgt. Allein im Jahr 2011 wurden weltweit mehr als 5 Milliarden solcher Plastikkarten hergestellt. Stand der Technik

Die EP 2 423 857 A1 betrifft ein Verfahren zum Herstellen einer mehrlagigen Trägerkarte im ID1-Format mit heraustrennbarer integrierter Chipmodulkarte.

Die DE 199 21 525 C2 betrifft eine Chipkarte mit einer entnehmbaren Chipmodulkarte. Hier wird eine Karte durch Stanzen oder Schneiden erzeugt, wobei der Stanz- oder Schneidvorgang so gesteuert wird, dass ein Kern nach dem Stanz- oder Schneidvorgang erhalten bleibt, der die Karte weiterhin mit dem Kartenkörper der Chipkarte verbindet. Eine Aussparung dient dazu, die Entnahme der Karte aus dem Kartenkörper zu erleichtern. Als Material für den Kartenkörper der Chipkarte ist hier insbesondere Papier, Pappe oder Karton mit ausreichender Elastizität genannt, was aus ökologischer Sicht vorzuziehen ist, insbesondere im Hinblick darauf, dass der Kartenkörper der Chipkarte in der Regel entsorgt wird, nachdem die Karte entnommen wurde.

Die DE 101 56 555 A1 betrifft eine Karte, in der eine Aussparung zur Aufnahme eines mit einem elektronischen Schaltkreis versehenen Miniaturmoduls (z. B. einer Mikro-SIM karte) vorgesehen ist. Das Miniaturmodul wird durch Eingießen im Träger ausgebildet und bildet einen in einem komplementär zur Form des Moduls ausgebildeten Ausschnitt des Trägers herausnehmbar eingelassenen, unabhängigen Teil. Der Träger besteht aus Pappe, starrem Papier oder einem gleichwertigen Werkstoff.

Die EP 07 42 926 B1 betrifft einen ein- oder mehrschichtigen Datenträger, insbesondere IC-Karten, mit eingebettetem elektronischen Modul, das zum Austausch von Daten mit einem externen Gerät dient, wobei der Datenträger aus Papier und/oder Karton besteht.

Dabei werden die für den Kartenaufbau benötigten Papierschichten, unabhängig davon, ob es sich bei der Karte um eine Einschicht- oder Mehrschichtkarte handelt, von der Rolle bereitgestellt, wodurch die Papier-IC-Karte in Endlostechnik zu fertigen ist. Die mehreren Schichten werden entweder kalt oder mit Hilfe dünner thermoaktivierbarer Kleber verklebt. Diese IC-Karte kann beispielsweise mit einem Tintenstrahldrucker bedruckt werden.

In einer Variante des dort beschriebenen Herstellungsverfahrens wird ein großer Bogen aus Papier und/oder Karton bereitgestellt, aus dem eine Vielzahl Karten hergestellt wird. Allerdings besteht hierbei das Problem, die herausgearbeiteten Konturen der einzelnen Lagen präzise zur Deckung zu bringen.

In einen Kartenkörper aus mehreren Papierschichten oder aus einer Kartonschicht wird das elektronische Modul eingeklebt, oder das elektronische Modul wird während der Herstellung der Karten in den Kartenkörper einlaminiert, indem das Modul entweder zwischen zwei Schichten eingebettet oder in eine Aussparung eingeklebt wird.

Ein mehrschichtiger Kartenaufbau entsteht durch Laminierung einer oberen Deckschicht, einer Kernschicht und einer unteren Deckschicht. Die Kernschicht ist beidseitig mit einer dünnen thermoaktivierbaren Klebeschicht versehen um die Schichten zu verkleben. Vor dem Zusammenführen der einzelnen Schichten werden in die Schichten und Fenster eingestanzt, so dass nach dem Zusammenführen und Verkleben der drei Schichten eine zweistufige Aussparung in dem Kartenkörper entsteht. Die Schichten werden von Rollen bereitgestellt und zur Laminierung durch geheizte Laminierrollen geführt, zwischen denen die thermoaktivierbaren Klebeschichten aktiviert werden. So entsteht ein Endloslaminat, das in entsprechenden Abständen mit den Aussparungen zur Aufnahme des elektronischen Moduls versehen ist. Aus diesem Endloslaminat werden in einem weiteren Verfahrens schritt die einzelnen Kartenkörper ausgestanzt. In die Aussparung des Kartenkörpers werden die elektronischen Module eingeklebt. Das Modul wird vor oder nach dem Ausstanzen der Karte in den Kartenkörper eingesetzt. Diese Vorgehensweise hat jedoch den Nachteil, dass schon bei geringen Positionsabweichungen die Aussparungskonturen der einzelnen Schichten nicht mehr fluchten und die Kanten ausgefranst sind.

Die DE 69 428 648 T2 betrifft eine IC-Karte mit einer trennbaren Minikarte und Verfahren zur Herstellung derselben. Dabei hat die IC-Karte einen Plattenrahmen aus Papiermaterialien, wie beispielsweise holzfreiem Papier, Beschichtungspapier und mit Harz imprägniertem Papier, Kunststoff- bzw. Plastikblättern aus Harz, wie beispielsweise Polyvinylchlorid, Polyethylenterephthalat, Polyvinylchlorid-Acetat-Copolymer, Polystyrol und Acrylnitril-Butadien-Styrol-Copolymer.

Die EP 2 521 073 A1 betrifft ein Verfahren zur Herstellung einer Karte mit einer Mikroschaltung und einem diese umgebenden Kartenkörper, wobei entlang der Kontur der Karte in den Kartenkörper Schlitze geschnitten werden, die durch Verbindungselemente getrennt sind, die die Karte mit dem umgebenden Kartenkörper verbinden. Der Kartenkörper besteht aus einem Material auf Cellulose-Basis.

Weiterer technologischer Hintergrund ist der CN 2014 38 312 U oder der JP 2001 357 376 A zu entnehmen.

Keine der bisherigen Varianten hat sich bisher im Markt durchgesetzt, obwohl ein erheblicher Bedarf an ökologisch verträglicheren Lösungen bei SIM-Karten besteht. Erschwert wird dies wohl auch durch die aus dem Material Papier resultierende fehlende Präzision bei der Herstellung der Papierträgerkarten mit heraustrennbarer integrierter Chipmodulkarte. Dies spielt jedoch bei zunehmender Miniaturisierung der Karten eine gesteigerte Rolle. So tritt sowohl bei der Herstellung mehrschichtiger Papierträgerkarten vom Bogen als auch bei deren Herstellung von der Rolle zur Rolle das Problem auf, dass sich das Papier verzieht. Damit sind die Aussparungen der einzelnen Schichten nicht exakt fluchtend zu einander ausgerichtet, was zu Problemen bei der anschließenden Montage des Chipmoduls in der durch die Aussparungen gebildeten Kavität führt.

### Zugrunde liegende Aufgabe

Die Aufgabe besteht darin, eine kostengünstige, schnell und dauerfest herzustellende Anordnung für eine Papierträgerkarte mit heraustrennbarer integrierter Chipmodulkarte bereit zu stellen. Die Aufgabe besteht außerdem darin, ein einfaches und kostengünstiges Verfahren zur Herstellung der Papierträgerkarte mit heraustrennbarer integrierter Chipmodulkarte sowie eine Vorrichtung zur Herstellung der Papierträgerkarte mit heraustrennbarer integrierter Chipmodulkarte anzugeben.

### Vorgeschlagene Lösung

Die Aufgabe wird gelöst durch eine Trägerkarte (einen SIM-Kartenhalter) aus Papier. So entsteht ein vollständig wiederverwertbarer, umweltfreundlicher SIM-Kartenhalter aus Papier, der überdies geringere Herstellungskosten hat und einfacher zu bedrucken ist.

Dazu hat das Verfahren zum Herstellen einer Trägerkarte mit heraustrennbarer integrierter Chipmodulkarte folgende Schritte:
- Bereitstellen einer Trägerkarte im ID1-Format aus einem ein- oder mehrlagigen Papier, wobei die einzelnen Lagen vorbestimmte Materialeigenschaften aufweisen, und die einzelnen Lagen mit wasserfestem Kleber verbunden sind,
   (a) Herstellen einer Kavität, wobei die Kavität ein- oder mehrstufig ist, so dass zumindest eine äußere und eine innere Teilkavität gebildet werden, durch
      (a1) erstes Ankerben der Trägerkarte entlang einer Kontur der in die Trägerkarte einzubringenden äußeren Teilkavität;
      (a2) Entfernen von Papiermaterial innerhalb der ersten Kontur zum Herstellen der in die Trägerkarte einzubringenden äußeren Teilkavität;
      (a4) Entfernen von Papiermaterial innerhalb einer zweiten Kontur der in die Trägerkarte einzubringenden inneren Teilkavität;
   (b) Ausformen der heraustrennbaren integrierten Chipmodulkarte/n im Mini-SIM -, Micro-SIM -, Nano-SIM -, und/oder Embedded-SIM - Format mit An- oder Durchkerbungen und/oder Stegen zwischen jeder der heraustrennbaren integrierten Chipmodulkarte/n und der übrigen Trägerkarte; und
   (c) Einkleben eines integrierten Chipmoduls in die Kavität.

Diese Vorgehensweise erlaubt das Herstellen einer positionsgenauen Kavität in einer Papierträgerkarte bzw. das Herstellen einer Papierträgerkarte mit heraustrennbarer Chipmodulkarte.

Die Schritte: -a2- und -a4- Entfernen von Papiermaterial können in einer Variante durch erstes Fräsen innerhalb der ersten Kontur, und / oder durch zweites Fräsen innerhalb der zweiten Kontur erfolgen.

In einer anderen Variante kann vor dem Schritt -a4- ein Schritt -a3- zweites Ankerben der Trägerkarte entlang der zweiten Kontur der in die Trägerkarte einzubringenden inneren Teilkavität erfolgen.

In einer weiteren Variante kann das Bereitstellen einer Trägerkarte aus einem mehrlagigen Papier umfassen, dass die einzelnen Papierlagen im Bereich der herzustellenden Kavität nicht verklebt sind.

Hierbei können die Schritte: -a2- und -a4- Entfernen von Papiermaterial durch erstes Heraussaugen des Papiermaterials innerhalb der ersten Kontur, und / oder durch zweites Heraussaugen des Papiermaterials innerhalb der zweiten Kontur erfolgen.

Der Schritt -c- Einkleben eines integrierten Chipmoduls in die Kavität kann vor oder nach dem Schritt -b- Ausformen der heraustrennbaren integrierten Chipmodulkarte/n zwischen jeder der heraustrennbaren integrierten Chipmodulkarte/n und der übrigen Trägerkarte ausgeführt werden.

Das erste und/oder das zweite Ankerben können jeweils auf eine Tiefe erfolgen, die mindestens der Tiefe der jeweiligen äußeren oder inneren Teilkavität entsprechen.

Die Karten können mit einem Laserstrahl beschriftet werden. Alternativ oder zusätzlich entfernt der Laserstrahl bei einer mit Farbe beschichteten Karte einen Teil der Farbe in Form der Beschriftung.

Im Unterschied zur Vorgehensweise im Stand der Technik, zum Beispiel EP 0 742 926 B1 wird das bei der hier vorgestellten Vorgehensweise das Papier nicht im Bogenformat oder von der Rolle verarbeitet, sondern jede Karte wird einzeln bearbeitet. Dies hat sich als die Genauigkeit bei der Herstellung der Kavität erheblich steigernde Vorgehensweise herausgestellt, so dass die Präzision des Gesamtprozesses einschließlich des Einklebens des integrierten Chipmoduls in die Kavität signifikant erhöht ist. Damit sinkt auch der Anteil der nicht akzeptablen Trägerkarten bei der Herstellung.

Dies liegt daran, dass im Stand der Technik die Positionierung der Ausstanzungen zueinander und der Abstand der anschließend ausgestanzten Karte vom integrierten Chipmodul zum Rand der Karten in der Praxis zu ungenau und schwer reproduzierbar sind. Im Bogenformat ist es außerdem schwierig im nächsten Prozessschritt exakt die nun zu fräsende und zuvor vorgestanzte/angekerbte Position wieder zu finden.

Demgegenüber wird hier vorgeschlagen, dass das erste und das zweite Ankerben jeweils auf eine Tiefe erfolgen, die mindestens der Tiefe der jeweiligen äußeren oder inneren Teilkavität entsprechen. Dabei kann das Ankerben jeweils auf eine Tiefe von etwa 200 - 300 Mikrometer erfolgen. Bei einer mehrlagigen Karte kann das Ankerben jeweils auf eine Tiefe erfolgen, die der Dicke der jeweils gekerbten Papierlage entspricht. Bei einer mehrlagigen Karte erfolgt das Fräsen jeweils auf eine Tiefe, die der Dicke der jeweils gekerbten Papierlage entspricht. So wird jeweils eine oder mehrere Papierlagen gekerbt bzw. gefräst und als Bodenfläche der (Teil-)Kavität ist eine Papieroberfläche der jeweiligen Papierlage freigelegt. So lässt sich eine genau gefräste Kavität mit einem glatten Boden erzielen. Sonst wäre der Boden uneben, was dazu führen kann, dass das zu implantierende Modul nicht ausreichend haftet oder ungenau oder mit einem Winkelfehler in die Kavität eingeklebt wird. Außerdem würde es durch die Unebenheit beim Messen der Tiefe der Kavität in der Serienfertigung zu Messfehlern kommen. Es ist jedoch auch möglich, nicht auf Schichthöhe zu kerben oder zu fräsen. In letzterem Fall ist eine der hier nachstehend beschriebenen Varianten eines Fräsers / Schneidwerkzeugs / Schälwerkzeugs von Vorteil, wegen der damit zu erzielenden Gestalt der (Teil-)Kavitäten und der ebenfalls damit erzielbaren glatten Wände der (Teil-)Kavitäten.

Da bei der hier vorgestellten Vorgehensweise erst die bereits komplette Trägerkarte mit der Kavität versehen wird, indem diese aus dem dann flächig vorliegenden Material einer einzigen Karte herausgearbeitet wird, ist sowohl die Position der Kavität als auch deren Gestalt durch die hier vorgeschlagene Vorgehensweise erheblich genauer als im Stand der Technik.

Ein sich gut für die Herstellung der vorgeschlagenen Trägerkarte eignendes Papiermaterial ist "Oppboga Green Card" mit einer

| **Größe** | **Prüfvorschrift** | **Einheit** | **Wert** |
|---|---|---|---|
| Flächenbezogene Masse | DIN EN ISO 536 | g/m² | 10 - 800 |
| Dicke | DIN EN ISO 534 | zum | 10 - 800 |
| Biegesteifigkeit | DIN EN ISO 5629 | mNm | |
| Resonanz mNm | | | |
| MD | | | 200 - 300 z.B. |
| CD | | | 309 |
| | | | 120 - 200 z.B. |
| | | | 167 |
| Rauigkeit | DIN EN ISO 8791-4 | PPS, µm | 0,8 - 1, 2 z.B. |
| | | | 1,0 |
| CIE-Weißegrad (D65/10°) | DIN EN ISO 11 475 | | 124 |
| Gefügefestigkeit (Scott bond) | Tappi 569 | J/m² | 100 - 300, z.B. |
| | | | 200 |

Bei einer mehrlagigen Trägerkarte werden drei oder mehr (zum Beispiel 4 oder 5, oder bis zu 10) Papierlagen mit unterschiedlicher oder gleicher Dicke verwendet.

Wenn dieses Papier verwendet wird, und, bei mehrlagigem Aufbau der Trägerkarte, zum Verbinden der Papierlagen ein wasserfester Kleber verwendet wird, steht ein sehr präzise kerb- und ausfräs- oder ausschälbarer Verbund zur Verfügung. Die Bearbeitung dieses Papiers, bzw. Papierverbunds führt zu erheblich besseren Ergebnissen hinsichtlich der Genauigkeit. Das führt zu geringeren Ausschuss bei der Serienproduktion, da das Chipmodul in eine präzise gefertigte Kavität auch mit vorhersehbarerem Erfolg einzufügen ist. Dieses Papier erlaubt, eine genau gefräste Kavität mit einem glatten Boden zu erzielen; dies ist mit anderen Papieren weniger gut möglich. Der Boden der Kavität wäre uneben, was zu einer verschlechterten Haftung und Ausrichtung des Chipmoduls in der Kavität führen könnte.

Beim Herstellen der Trägerkarte mit heraustrennbarer integrierter Chipmodulkarte können die Schritte -a-, -b- und -c- in der Reihenfolge -a-, dann -b-, und dann -c-, oder in der Reihenfolge -a-, dann -c-, und dann -b-, oder in der Reihenfolge -b-, dann -a-, und dann -c- ausgeführt werden.

Die Schritte -a1-, -a2-, -a3-, und -a4- können in der Reihenfolge -a1-, dann -a2-, dann -a3-, und dann -a4-, oder in der Reihenfolge -a1-, dann -a3-, dann -a2-, und dann -a4-, ausgeführt werden.

In einer Variante erfolgt der Schritt -a4- vor dem Schritt -a2-. Bei dieser Vorgehensweise werden beim Erzeugen der größeren Kavität Unebenheiten an den Kanten der inneren Kavität - soweit entstanden - teils wieder mit entfernt. Zusätzlich oder stattdessen kann der der Schritt -a4- vor dem Schritt -a1- erfolgen.

Die Schritte -a1- und -a3- können mit folgenden Kerbparametern ausgeführt werden: Kerbwinkel: 5 - 15 Grad nach außen und 25 - 35 Grad nach innen. In einer Variante wird ein Kerbwinkel von 40 Grad verwendet.

Die Schritte -a2- und -a4- Entfernen von Papiermaterial innerhalb der ersten bzw. der zweiten Kontur zum Herstellen der in die Trägerkarte einzubringenden äußeren bzw. inneren Teilkavität werden bevorzugt so ausgeführt, dass die äußere Teilkavität und die innere Teilkavität jeweils eine zum Grund der Kavität hin sich verjüngende kegelstumpfförmige äußere Mantelfläche bzw. innere Mantelfläche mit einem Kegelwinkel zwischen 12 Grad und etwa 20 Grad oder 25 Grad haben. Diese Gestalt wird vorzugsweise mit einem entsprechend geformten und dimensionierten Schneid- oder Fräswerkzeug realisiert. Dabei kann die Neigung der zum Grund der Kavität hin sich verjüngende kegelstumpfförmigen äußeren Mantelfläche bzw. inneren Mantelfläche eine präzisere Formgebung der Kavität im Papiermaterial bewirken. Überdies vergrößert sich durch die schräge äußere Mantelfläche bzw. innere Mantelfläche die seitliche Haftfläche des Heißklebers und der Einbettmasse.

Bei einer hier beschriebenen Chipmodulkarte mit einer mehrlagigen Karte haben die Papiere für die einzelnen Lagen unterschiedliche oder gleiche Dicke.

Die hier beschriebene Chipmodulkarte mit einer mehrlagigen Karte ist aus einer Trägerkarte heraustrennbar. Dabei ist ein Chipmodul in einer Kavität mit einer äußeren und einer inneren Teilkavität aufgenommen, wobei die äußere Teilkavität und / oder die innere Teilkavität jeweils eine zum Grund der Kavität hin sich verjüngende kegelstumpfförmige äußere Mantelfläche bzw. innere Mantelfläche mit einem Kegelwinkel zwischen 12 Grad und etwa 20 Grad haben.

### Kurzbeschreibung der Zeichnung

Weitere Ziele, Merkmale, Vorteile und Anwendungsmöglichkeiten ergeben sich aus der nachfolgenden Beschreibung einiger Ausführungsbeispiele und zugehöriger Zeichnungen. Dabei bilden alle beschriebenen und/oder bildlich dargestellten Merkmale für sich oder in beliebiger Kombination den hier offenbarten Gegenstand, auch unabhängig von ihrer Gruppierung in den Ansprüchen oder deren Rückbeziehungen.
Fig. 1 zeigt eine schematische Draufsicht einer Trägerkarte mit heraustrennbarer integrierter Chipmodulkarte mit Ankerbungen und Stegen zwischen jeder heraustrennbaren integrierten Chipmodulkarte und der übrigen Trägerkarte.
Fig. 2 zeigt schematisch die Trägerkarte aus Fig. 1 in einer Schnittansicht längs der Linie A---A in der Fig. 1.
Fig. 3 - Fig. 7 zeigen schematisch Schritte eines Herstellungsverfahrens der Trägerkarte aus Fig. 1.
Fig. 8 zeigt schematisch einen Schäler mit Wendeschneidplatte zum Entfernen von Papiermaterial aus den beiden Teilkavitäten, wobei Fig. 8a eine stirnseitige Draufsicht und Fig. 8b eine vergrößerte seitliche Ansicht der Wendeschneidplatte zeigen.
Fig. 9 zeigt schematisch das in den Fig. 3 - 7 eingesetzte Kerbmesser in einer seitlichen Schnittansicht.
Fig. 10 zeigt schematisch eine Maschine, in der die in den Fig. 3 - 7 veranschaulichten Schritte ausgeführt werden.

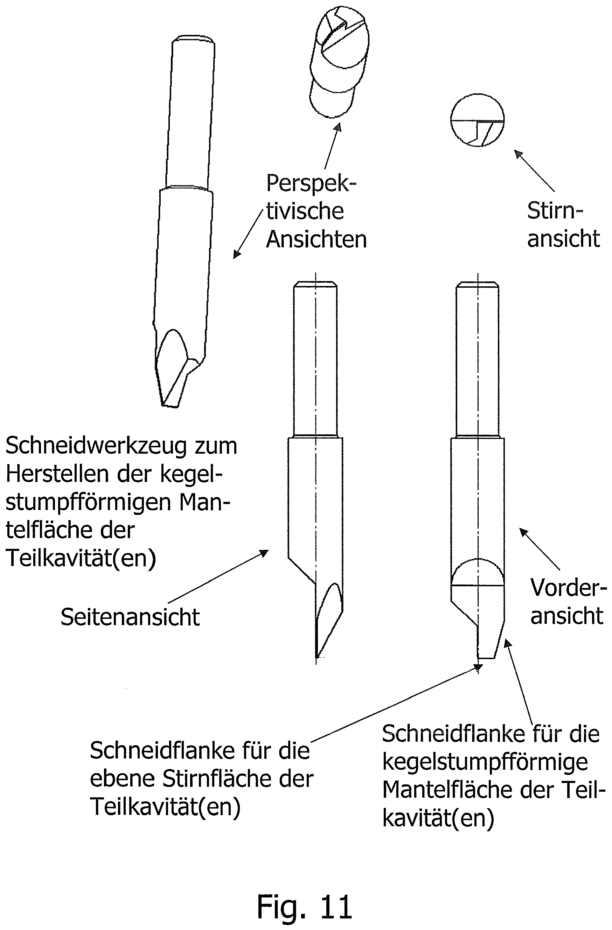

Fig. 11 zeigt schematisch ein Schneid-/Fräswerkzeug in unterschiedlichen Ansichten um die Teilkavitäten mit schräg geneigten, zum Grund der Kavität hin sich verjüngenden, kegelstumpfförmigen Mantelflächen herauszuarbeiten.

### Detaillierte Beschreibung

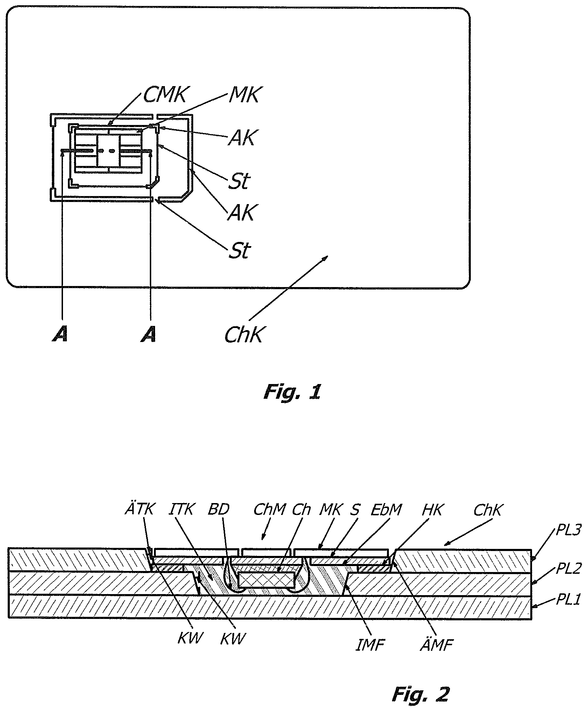

In Fig. 1 ist eine Trägerkarte TK im ID1-Format mit einer heraustrennbaren integrierten Chipmodulkarte CMK, die als **s**ubscriber **i**dentity **m**odule dient, veranschaulicht. Dabei ist die Chipmodulkarte CMK von Ankerbungen AK und Stegen St umgeben. Zur vielseitigeren Einsetzbarkeit der Chipmodulkarte CMK sind die Ankerbungen AK und Stege St so um die Chipmodulkarte CMK angeordnet, dass die Chipmodulkarte CMK in unterschiedlichen Formaten aus der Trägerkarte TK heraustrennbar ist. Die hier gezeigte Variante umfasst eine Trägerkarte TK, aus der eine Chipmodulkarte CMK entweder im Mini-SIM-Kartenformat oder im Micro-SIM-Kartenformat herausgebrochen werden kann. Es sind aber auch andere oder weitere Kartenformat-Kombinationen möglich.

Die Trägerkarte TK im ID1-Format ist in der vorliegenden Variante aus einem mehrlagigen, genauer einem dreilagigen Papier aufgebaut, dessen einzelne Lagen PL1, PL2, PL3 vorbestimmte Materialeigenschaften und mit einem wasserfestem Kleber flächig verbunden sind.

Wie auch in der Fig. 2 veranschaulicht, ist in der Trägerkarte TK eine Kavität K ausgebildet, die hier mehrstufig, genauer zweistufig aufgebaut ist. So sind eine äußere Teilkavität ÄTK und eine innere Teilkavität ITK gebildet. Dabei reicht die innere Teilkavität ITK von einer Oberseite OS der Trägerkarte TK durch die obere und die mittlere Papierlage PL3 und PL2 bis zur unteren Papierlage PL1. Die innere Teilkavität ITK hat einen im Vergleich zur äußeren Teilkavität ÄTK - in der Draufsicht - einen geringeren (etwa kreisrunden) Querschnitt. Die äußere Teilkavität ÄTK reicht von der Oberseite OS der Trägerkarte TK durch die obere Papierlage PL2 zur mittleren Papierlage PL3. Die äußere Teilkavität ÄTK hat - in der Draufsicht - einen im Vergleich zur inneren Teilkavität ITK größeren Querschnitt, dessen Gestalt in der Draufsicht dem jeweiligen in die Kavität eingeklebten Chipmodul ChM, genauer dessen Kontaktlayout, in etwa entspricht. Dabei haben in der hier veranschaulichten Variante die äußere Teilkavität ÄTK und die innere Teilkavität ITK jeweils eine zum Grund der Kavität hin sich verjüngende kegelstumpfförmige äußere Mantelfläche ÄMF bzw. innere Mantelfläche IMF. Hierbei haben beiden Mantelflächen ÄMF, IMF einen Kegelwinkel KW zwischen 12 Grad und etwa 20 Grad; in der vorliegenden Variante ist der Kegelwinkel KW etwa 15° gegenüber der in Fig. 2 gestrichelt eingezeichneten Senkrechten. Dabei kann auch nur eine der beiden Teilkavitäten eine zum Grund der Kavität hin sich verjüngende kegelstumpfförmige äußere Mantelfläche ÄMF bzw. innere Mantelfläche IMF haben, während die jeweils andere der beiden Teilkavitäten eine senkrechte, oder annähernd senkrechte Mantelfläche hat. Unter annähernd senkrecht sei hier eine Mantelfläche verstanden, deren Neigung gegenüber der Senkrechten ca. 10° oder weniger beträgt.

Das in die Kavität eingeklebte Chipmodul ChM hat ein Substrat S, auf dessen in Fig. 2 oberen (Außen-)Seite mehrere Metallkontaktflächen MK ausgebildet sind. An der in Fig. 2 unteren (Innen-)Seite des Substrats S ist in dessen Zentrum mittels eines Chipklebers ChK ein Chip Ch angeklebt, der einen einfachen Microprozessor mit Speicher enthält. Mit einer **P**ersonal **I**dentification **N**umber PIN kann dieser Chip vor unbefugter Benutzung geschützt werden. Durch das SIM wird ein Mobiltelefon in ein Mobilfunknetz eingebucht und darin authentifiziert. Dazu enthält der Speicher des SIM persönliche Nummern und Algorithmen gespeichert, die auch der Verschlüsselung der übertragenen Sprach- und sonstigen Daten dienen.

Durch Öffnungen in dem Substrat S reichen von der in Fig. 2 unteren (Innen-)Seite der Metallkontaktflächen MK Bonddrähte BD zu dem Chip Ch. Der Chip Ch und die Bonddrähte BD sind in einer Einbettungsmasse EBM aufgenommen, die den Chip Ch und die Bonddrähte BD elektrisch und mechanisch vor Umwelteinflüssen schützt.

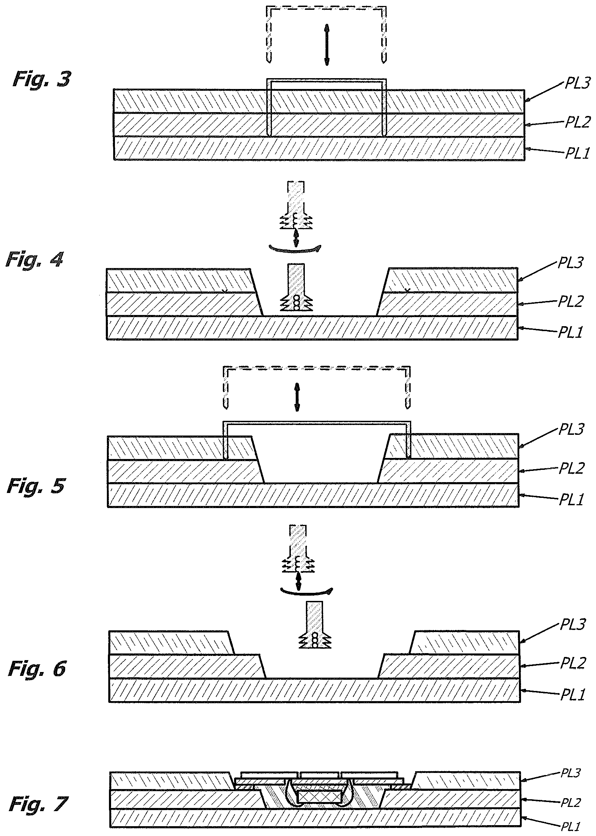

In den Fig. 3 - 7 ist eine mögliche Variante des Verfahrens zum Herstellen einer Trägerkarte mit heraustrennbarer integrierter Chipmodulkarte veranschaulicht.

Gemäß Fig. 3 wird eine einzelne Trägerkarte im ID1-Format einem mehrlagigen, hier dreilagigen Papier bereitgestellt. Die einzelnen Lagen haben weiter unten erläuterte, vorbestimmte Materialeigenschaften. Die einzelnen Lagen des Papiers sind mit wasserfestem Kleber fest verbunden.

Zunächst wird eine Kavität gebildet, wobei die Kavität ein- oder mehrstufig, hier zweistufig ist. Dazu werden eine äußere und eine innere Teilkavität gebildet.

Wie in Fig. 3 gezeigt, wird die einzelne Trägerkarte zunächst einem ersten Ankerben entlang einer Kontur der in die Trägerkarte einzubringenden inneren Teilkavität unterzogen. Dazu wird ein kreisringförmiges erstes Kerbmesser in die einzelne Trägerkarte gesenkt um die in Fig. 3 obere und mittlere Papierlage PL3 und PL2 einzukerben. Dabei wird das erste Kerbmesser soweit in den Verbund der drei Papierlagen PL1, PL2, PL3 gesenkt, dass das erste Kerbmesser mit seiner Kerbkante bis zur oberen Oberfläche der untersten Papierlage PL1 durchkerbt.

Anschließend wird, wie in Fig. 4 veranschaulicht, die einzelne Trägerkarte einem Entfernen von Papiermaterial innerhalb der ersten Kontur unterzogen, um die in die Trägerkarte einzubringende innere Teilkavität herzustellen. Dazu wird ein Fräskopf in Rotation versetzt und in den von dem ersten Kerbmesser ausgestochenen Bereich der oberen und mittleren Papierlage PL3 und PL2 eingefahren. Das herausgefräste Papiermaterial kann dabei abgesaugt werden.

Als nächste Schritte zeigen die Fig. 5 und 6 das Entfernen von Papiermaterial innerhalb einer zweiten Kontur der in die Trägerkarte einzubringenden äußeren Teilkavität. Hierbei wird zunächst analog zu dem in Fig. 3 gezeigten Schritt die einzelne Trägerkarte einem zweiten Ankerben entlang einer Kontur der in die Trägerkarte einzubringenden äußeren Teilkavität unterzogen. Dazu wird ein kreisringförmiges zweites Kerbmesser in die einzelne Trägerkarte gesenkt um die in Fig. 5 obere Papierlage PL3 einzukerben. Das zweite Kerbmesser hat einen größeren Querschnitt als das erste Kerbmesser. Das zweite Kerbmesser wird soweit in die oberste Papierlage PL3 gesenkt, dass das zweite Kerbmesser mit seiner Kerbkante bis zur oberen Oberfläche der mittleren Papierlage PL2 in Fig. 5 durchkerbt.

Danach wird, wie in Fig. 6 veranschaulicht, die einzelne Trägerkarte einem Entfernen von Papiermaterial innerhalb der zweiten Kontur unterzogen, um die in die Trägerkarte einzubringende äußere Teilkavität herzustellen. Dazu wird ein Fräskopf in Rotation versetzt und in den von dem zweiten Kerbmesser ausgestochenen Bereich der oberen Papierlage PL3 eingefahren. Das herausgefräste Papiermaterial kann dabei abgesaugt werden.

Vor dem Einsetzen des Chipmoduls erfolgt noch das Ausformen der heraustrennbaren integrierten Chipmodulkarte/n im Mini-SIM - und Micro-SIM -Kartenformat mit den in Fig. 1 veranschaulichten An- und Durchkerbungen und Stegen zwischen der heraustrennbaren integrierten Chipmodulkarte und der übrigen Trägerkarte. Dazu dienen hier nicht weiter veranschaulichte Kerbmesser bzw. Fräsen, mit welchen die Trägerkarte entsprechend bearbeitet wird.

Schließlich erfolgt das Einkleben des integrierten Chipmoduls in die Kavität. Dabei wird auf den stufenförmigen Übergang St zwischen der inneren und der äußeren Teilkavität ein Heißkleber HK aufgebracht, der das Substrat S des integrierten Chipmoduls im Randbereich auf dem stufenförmigen Übergang St sicher und formstabil befestigt. Dabei wird durch die präzise Ausformung der Stufe am Übergang zwischen der inneren und der äußeren Teilkavität und die durch die hier vorgestellten Kerb- und Fräsvorgänge exakt herausgearbeitete Gestalt und die Dimensionen der Kavität gewährleistet, dass die freiliegende Oberseite der Metallkontakte des integrierten Chipmoduls bündig mit dessen Umgebung der integrierten Chipmodulkarte abschließt. So wird erreicht, dass eine in ein elektronisches Gerät (Mobiltelefon, Tabletcomputer etc.) eingeschobene Chipmodulkarte beim Einschieben nicht an einer Kante hängen bleibt und dabei beschädigt wird.

Ebenso wird durch die Einbettmasse des integrierten Chipmoduls zusammen mit der untersten Papierlage PL1 sichergestellt, dass der Chip und dessen Bonddrähte in der Kavität auch von der Unterseite der Chipmodulkarte her gut geschützt sind. Insbesondere sind dabei auch durch die durch die hier vorgestellten Kerb- und Fräsvorgänge die Gestalt und die Dimensionen der Kavität exakt herausgearbeitet. Auch dies vermeidet, dass zum Beispiel das integrierte Chipmodul durch Unebenheiten des Bodens der inneren Teilkavität auf dem Boden asymmetrisch aufsitzt. Dies hätte in nachteiliger Weise zur Folge, dass die freiliegende Oberseite der Metallkontakte MK des integrierten Chipmoduls nicht bündig mit dessen Umgebung der integrierten Chipmodulkarte abschließt, sondern zur Oberfläche der Chipmodulkarte geneigt ist und dementsprechend diese teilweise über- oder unterragt.

Demgegenüber erreicht die hier beschrieben Vorgehensweise, dass die freiliegende Oberseite der Metallkontakte des integrierten Chipmoduls eben und bündig mit dessen Umgebung der integrierten Chipmodulkarte abschließt.

Die Chipmodulkarte kann mit unterschiedlichen Schlitzen und Stegen in der Trägerkarte geformt sein. Optional können die Stege, welche die Chipmodulkarte in der Trägerkarte halten, auch angekerbt sein. In einer Variante wird mit dem Stanzen der Umrisse der Chipmodulkarte begonnen und erst dann ankerbt / vorstanzt, gefräst und implantiert. Aus Gründen der Genauigkeit und Stabilität ist es vorteilhaft, zuerst anzukerben / zu fräsen und zu implantieren und erst danach die Umrisse der Chipmodulkarte in die Trägerkarte zu stanzen. Andere Reihenfolgen funktionieren aber auch. Es ist jedoch bevorzugt, vor dem Implantieren die Umrisse zu stanzen um das Chipmodul keiner unnötigen Belastung oder Erschütterung auszusetzen.

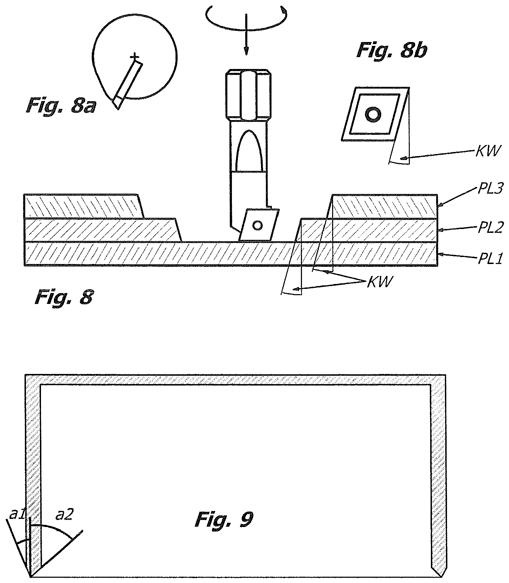

Anstelle der Fräsers kann auch ein Schäler, zum Beispiel mit Wendeschneidplatte, zum Entfernen von Papiermaterial innerhalb der ersten und / oder der zweiten Kontur der beiden Teilkavitäten eingesetzt werden. Siehe hierzu schematisch das in der Fig. 8 veranschaulichte Werkzeug.

Um eine Trägerkarte mit heraustrennbarer integrierter Chipmodulkarte der hiervorgestellten Art besonders maßhaltig und gestalttreu herzustellen, wird als Papier ein zellulosehaltiges Material mit folgenden Eigenschaften verwendet:

| **Größe** | **Prüfvorschrift** | **Einheit** | **Wert** |
|---|---|---|---|
| Flächenbezogene Masse | DIN EN ISO 536 | g/m² | 10 - 800 |
| Dicke | DIN EN ISO 534 | µm | 10 - 800 |
| Biegesteifigkeit | DIN EN ISO 5629 | mNm | |
| Resonanz mNm | | | |
| MD | | | 200 - 300 z.B. |
| CD | | | 309 |
| | | | 120 - 200 z.B. |
| | | | 167 |
| Rauigkeit | DIN EN ISO 8791-4 | PPS, µm | 0,8 - 1, 2 z.B. |
| | | | 1,0 |
| CIE-Weißegrad (D65/10°) | DIN EN ISO 11 475 | | 124 |
| Gefügefestigkeit (Scott bond) | Tappi 569 | J/m² | 100 - 300, z.B. |
| | | | 200 |

Die schematische Wiedergabe der Trägerkarte in den vorstehend erläuterten Fig. ist insoweit auch proportionenkorrekt, als hier für die einzelnen Lagen Papiere mit gleicher Dicke verwendet werden. Dies erlaubt eine einfache Herstellung der einzelnen Karten. Eingangs wurde bereits erläutert, dass die Reihenfolge der einzelnen Schritte, variiert werden kann. Außerdem können einzelne Schritte weggelassen werden.

Zum Entfernen von Papiermaterial innerhalb der ersten bzw. der zweiten Kontur zum Herstellen der in die Trägerkarte einzubringenden äußeren bzw. inneren Teilkavität kann in einer Variante ein Fräser oder ein Schneidwerkzeug verwendet werden, der so gestaltet ist, dass die äußere Teilkavität und die innere Teilkavität jeweils eine zum Grund der Kavität hin sich verjüngende kegelstumpfförmige äußere Mantelfläche bzw. innere Mantelfläche mit einem Kegelwinkel zwischen 12 Grad und etwa 20 Grad haben. Vorzugsweise ist die Geometrie des Fräsers oder des Schneidwerkzeugs so getroffen, dass durch das Schneid-/ Fräswerkzeug die äußere Teilkavität und die innere Teilkavität jeweils eine zum Grund der Kavität hin sich verjüngende kegelstumpfförmige äußere Mantelfläche bzw. innere Mantelfläche mit einem Kegelwinkel von 15 Grad haben.

Je nach der Gestalt des Chipmoduls können die äußere Teilkavität und die innere Teilkavität jeweils eine zum Grund der Kavität hin sich verjüngende kegelstumpfförmige äußere Mantelfläche bzw. innere Mantelfläche haben. Es ist jedoch auch möglich, nur eine der beiden Teilkavitäten mit einer sich verjüngenden kegelstumpfförmigen Mantelfläche auszugestalten.

Das Kerbmesser kann folgende Charakteristiken haben: Das Kerbmesser hat eine kreisrunde hohlzylindrische Klinge mit einer Klingenhöhe von etwa 3 - 10 mm und eine Klingendicke von etwa 0,2 - 1,2 mm. Seine Kerbkante ist asymmetrisch gestaltet, wobei sie mit einem Winkel a1 von um 5 - 25 Grad relativ zur Senkrechten nach außen geneigt ist, im in Fig. 9 gezeigten Beispiel 20 Grad nach außen und mit einem Winkel a2 von 25 - 55 Grad relativ zur Senkrechten nach innen, im in Fig. 9 gezeigten Beispiel etwa 40 Grad nach innen geneigt ist. Diese Angaben gelten sowohl für das Kerbmesser für die innere als auch für das Kerbmesser für die äußere Teilkavität.

Wenn im angekerbten Bereich in der Größe der äußeren Teilkavität zuerst die kleinere, tiefere innere Teilkavität ausgefräst wird und anschließend entsprechend der Größe des angekerbten Bereichs die zweite, größere, weniger tiefe Teilkavität gefräst wird, hat den Vorteil, dass ein bei der kleineren, tieferen inneren Teilkavität entstandene Grat wieder weggefräst wird. Das Fräswerkzeug kann aus Standard Hartmetall sein.

Bevorzugt hat die Trägerkarte eine oder mehrere Passermarken oder Referenzkanten zur Positionierung der Kerbmesser und der Fräser / Schäler in den X- und Y-Koordinaten. Dann wird in jeder Bearbeitungsstation (Kerben / Fräsen oder Schälen) die Trägerkarte zu denselben Passermarken (Indexmarken) positioniert. So deckt sich die Fräskontur exakt mit der Prägekontur und die Position der Fräskavitäten zu den Passermarken oder Referenzkanten der Trägerkarte liegen in der geforderten Toleranz.

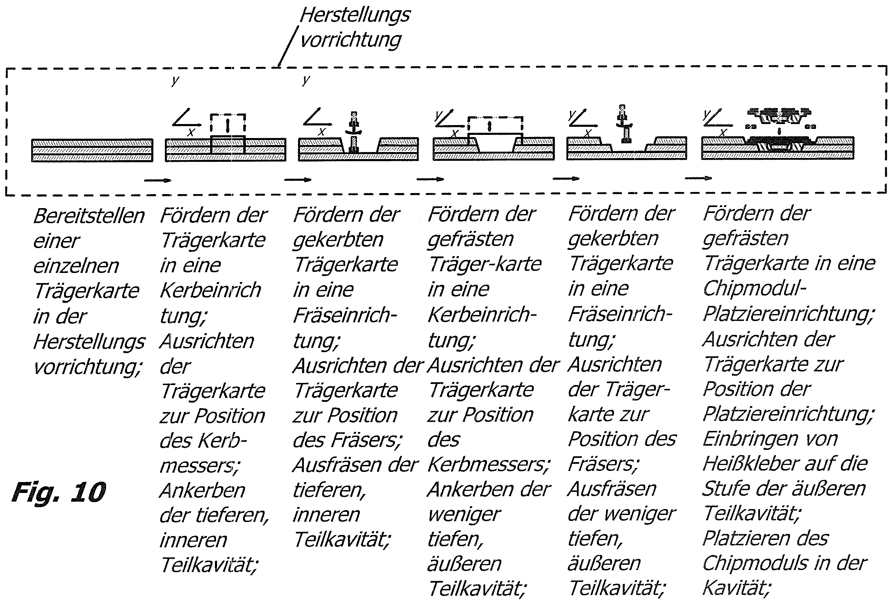

Die in Fig. 10 schematisch gezeigte Maschine, in der die in den Fig. 3 - 7 veranschaulichten Schritte ausgeführt werden kann entweder als integrale Anordnung realisiert sein oder als Zusammenstellung einzelner Module, bei denen die Kerbmesser bzw. Fräsköpfe durch entsprechende Linear- und Drehantriebe betätigt werden. Die einzelnen Module sind über eine Transporteinrichtung für die einzelne Trägerkarte miteinander gekoppelt und werden durch eine zentrale Maschinensteuerung betätigt.

Die vorangehend beschriebenen Varianten des Verfahrens und der Vorrichtung dienen lediglich dem besseren Verständnis der Struktur, der Funktionsweise und der Eigenschaften der vorgestellten Lösung; sie schränken die Offenbarung nicht etwa auf die Ausführungsbeispiele ein. Die Fig. sind schematisch, wobei wesentliche Eigenschaften und Effekte zum Teil deutlich vergrößert dargestellt sind, um die Funktionen, Wirkprinzipien, technischen Ausgestaltungen und Merkmale zu verdeutlichen. Dabei kann jede Funktionsweise, jedes Prinzip, jede technische Ausgestaltung und jedes Merkmal, welches / welche in den Fig. oder im Text offenbart ist/sind, mit allen Ansprüchen, jedem Merkmal im Text und in den anderen Fig., anderen Funktionsweisen, Prinzipien, technischen Ausgestaltungen und Merkmalen, die in dieser Offenbarung enthalten sind oder sich daraus ergeben, frei und beliebig kombiniert werden, so dass alle denkbaren Kombinationen der beschriebenen Lösung zuzuschreiben sind. Dabei sind auch Kombinationen zwischen allen einzelnen Ausführungen im Text, das heißt in jedem Abschnitt der Beschreibung, in den Ansprüchen und auch Kombinationen zwischen verschiedenen Varianten im Text, in den Ansprüchen und in den Fig. umfasst.

Die vorstehend erläuterten Vorrichtungs- und Verfahrensdetails sind zwar im Zusammenhang dargestellt; es sei jedoch darauf hingewiesen, dass sie auch unabhängig voneinander sind und auch frei miteinander kombinierbar sind. Die in den Fig. gezeigten Verhältnisse der einzelnen Teile und Abschnitte hiervon zueinander und deren Abmessungen und Proportionen sind nicht einschränkend zu verstehen. Vielmehr können einzelne Abmessungen und Proportionen auch von den gezeigten abweichen.

Auch die Ansprüche limitieren nicht die Offenbarung und damit die Kombinationsmöglichkeiten aller aufgezeigten Merkmale untereinander. Alle aufgezeigten Merkmale sind explizit auch einzeln und in Kombination mit allen anderen Merkmalen hier offenbart.

## Patentansprüche

1. Verfahren zum Herstellen einer Trägerkarte (TK) mit heraustrennbarer integrierter Chipmodulkarte, (CMK) mit folgenden Schritten:
- Bereitstellen einer Trägerkarte im (TK) ID1-Format aus einem ein- oder mehrlagigen Papier, wobei die einzelnen Lagen (PL1, PL2, PL3) vorbestimmte Materialeigenschaften aufweisen, und die einzelnen Lagen mit wasserfestem Kleber verbunden sind,
- a- Herstellen einer Kavität, wobei die Kavität ein- oder mehrstufig ist, so dass zumindest eine äußere (ÄTK) und eine innere (ITK) Teilkavität gebildet werden, durch
- a1- erstes Ankerben der Trägerkarte (TK) entlang einer Kontur der in die Trägerkarte (TK) einzubringenden äußeren Teilkavität; (ÄTK)
- a2- Entfernen von Papiermaterial innerhalb der ersten Kontur zum Herstellen der in die Trägerkarte (TK) einzubringenden äußeren Teilkavität; (ÄTK)
- a4- Entfernen von Papiermaterial innerhalb einer zweiten Kontur der in Trägerkarte (TK) einzubringenden inneren Teilkavität; (ITK)
- b- Ausformen der heraustrennbaren integrierten Chipmodulkarte/n (CMK) im Mini-SIM -, Micro-SIM -, Nano-SIM -, und/oder Embedded-SIM - Format mit An- oder Durchkerbungen (AK) und/oder Stegen (St) zwischen jeder heraustrennbaren integrierten Chipmodulkarte/n (CMK) und der übrigen Trägerkarte; (TK) und
- c- Einkleben eines integrierten Chipmoduls (ChM) in die Kavität.

2. Verfahren zum Herstellen einer Trägerkarte (TK) mit heraustrennbarer integrierter Chipmodulkarte (CMK) nach dem vorhergehenden Anspruch, wobei die Schritte:
Entfernen von Papiermaterial durch erstes Fräsen innerhalb der ersten Kontur, und / oder durch zweites Fräsen innerhalb der zweiten Kontur erfolgen,
und/oder, wobei vor dem Schritt -a4- ein Schritt -a3- zweites Ankerben der Trägerkarte (TK) entlang der zweiten Kontur der in die Trägerkarte (TK) einzubringenden inneren Teilkavität (ITK) erfolgt, und/oder, wobei das Bereitstellen einer Trägerkarte (TK) aus einem mehrlagigen Papier umfasst,
dass die einzelnen Papierlagen im Bereich der herzustellenden Kavität nicht verklebt sind.

3. Verfahren zum Herstellen einer Trägerkarte (TK) mit heraustrennbarer integrierter Chipmodulkarte (CMK) nach dem vorhergehenden Anspruch, wobei die Schritte:
- a1- und -a4- Entfernen von Papiermaterial durch erstes Heraussaugen des Papiermaterials innerhalb der ersten Kontur, und / oder durch zweites Heraussaugen des Papiermaterials innerhalb der zweiten Kontur erfolgen.

4. Verfahren zum Herstellen einer Trägerkarte (TK) mit heraustrennbarer integrierter Chipmodulkarte (CMK) nach Anspruch 1, wobei
- das erste und/oder das zweite Ankerben jeweils auf eine Tiefe erfolgen, die mindestens der Tiefe der jeweiligen äußeren oder inneren Teilkavität (ITK) entsprechen, und/oder wobei
- das Ankerben jeweils auf eine Tiefe von etwa 200 - 300 Mikrometer erfolgt, und/oder wobei
- das Fräsen jeweils auf eine Tiefe von etwa 200 - 300 Mikrometer erfolgt, und/oder wobei
- bei einer mehrlagigen Karte das Ankerben jeweils auf eine Tiefe erfolgt, die der Dicke der jeweils gekerbten Papierlage entspricht, und/oder wobei
- bei einer mehrlagigen Karte das Fräsen jeweils auf eine Tiefe erfolgt, die der Dicke der jeweils gekerbten Papierlage/n entspricht.

5. Verfahren zum Herstellen einer Trägerkarte mit heraustrennbarer integrierter Chipmodulkarte (CMK) nach einem der vorhergehenden Ansprüche, wobei der Schritt
- c- Einkleben eines integrierten Chipmoduls (ChM) in die Kavität vor oder nach dem Schritt -b- Ausformen der heraustrennbaren integrierten Chipmodulkarte/n (CMK) zwischen jeder der heraustrennbaren integrierten Chipmodulkarte/n (CMK) und der übrigen Trägerkarte (TK) ausgeführt wird.

6. Verfahren zum Herstellen einer Trägerkarte (TK) mit heraustrennbarer integrierter Chipmodulkarte (CMK) nach einem der vorhergehenden Ansprüche, wobei als Papier ein zellulosehaltiges Material mit folgenden Eigenschaften verwendet wird:
| **Größe** | **Prüfvorschrift** | **Einheit** | **Wert** |
|---|---|---|---|
| Flächenbezogene Masse | DIN EN ISO 536 | g/m² | 10 - 800 |
| Dicke | DIN EN ISO 534 | µm | 10 - 800 |
| Biegesteifigkeit | DIN EN ISO 5629 | mNm | |
| Resonanz mNm | | | |
| MD | | | 200 - 300 z.B. |
| CD | | | 309 |
| | | | 120 - 200 z.B. |
| | | | 167 |
| Rauigkeit | DIN EN ISO 8791-4 | PPS, µm | 0,8 - 1, 2 z.B. |
| | | | 1,0 |
| CIE-Weißegrad (D65/10°) | DIN EN ISO 11 475 | | 124 |
| Gefügefestigkeit (Scott bond) | Tappi 569 | J/m² | 100 - 300, z.B. |
| | | | 200 |

7. Verfahren zum Herstellen einer Trägerkarte (TK) mit heraustrennbarer integrierter Chipmodulkarte (CMK) nach einem der vorhergehenden Ansprüche, wobei bei einer mehrlagigen Karte für die einzelnen Lagen Papiere (PL1, PL2, PL3) mit unterschiedlicher oder gleicher Dicke verwendet werden.

8. Verfahren zum Herstellen einer Trägerkarte (TK) mit heraustrennbarer integrierter Chipmodulkarte (CMK) nach einem der vorhergehenden Ansprüche, wobei der Schritt
- a4- vor dem Schritt -a2- und/oder der Schritt -a4- vor dem Schritt -a1- erfolgt, und/oder wobei
die Schritte -a-, -b- und -c-
in der Reihenfolge -a-, dann -b-, und dann -c-, oder
in der Reihenfolge -a-, dann -c-, und dann -b-, oder
in der Reihenfolge -b-, dann -a-, und dann -c-
ausgeführt werden, und/oder wobei die Schritte
- a1-, -a2-, ggf. -a3-, und -a4-
in der Reihenfolge -a1-, dann -a2-, ggf. dann -a3-, und dann -a4-, oder in der Reihenfolge -a1-, ggf. dann -a3-, dann -a2-, und dann -a4-,

9. Verfahren zum Herstellen einer Trägerkarte (TK) mit heraustrennbarer integrierter Chipmodulkarte (CMK) nach einem der vorhergehenden Ansprüche, wobei die Schritte
- a1- und ggf. -a3- mit folgenden Kerbparametern ausgeführt werden: 5 -15 Grad nach außen und 25 - 35 Grad nach innen.

10. Verfahren zum Herstellen einer Trägerkarte (TK) mit heraustrennbarer integrierter Chipmodulkarte (CMK) nach einem der vorhergehenden Ansprüche, wobei die Schritte
- a2- und -a4- Entfernen von Papiermaterial innerhalb der ersten bzw. der zweiten Kontur zum Herstellen der in die Trägerkarte (TK) einzubringenden äußeren (ÄTK) bzw. inneren Teilkavität (ITK) so ausgeführt werden, dass die äußere Teilkavität (ÄTK) und die innere Teilkavität (ITK) jeweils eine zum Grund der Kavität hin sich verjüngende kegelstumpfförmige äußere Mantelfläche bzw. innere Mantelfläche mit einem Kegelwinkel zwischen 12 Grad und etwa 20 Grad haben.

11. vorrichtung zum Herstellen einer Trägerkarte (TK) mit heraustrennbarer integrierter Chipmodulkarte, (CMK) mit
- einem Modul zum Bereitstellen einer Trägerkarte (TK) im ID1-Format aus einem ein- oder mehrlagigen Papier, wobei die einzelnen Lagen (PL1, PL2, PL3) vorbestimmte Materialeigenschaften aufweisen, und die einzelnen Lagen (PL1, PL2, PL3) mit wasserfestem Kleber verbunden sind,
- einer Vorrichtung zum Herstellen einer Kavität, wobei die Kavität ein- oder mehrstufig ist, so dass zumindest eine äußere (ÄTK) und eine innere Teilkavität (ITK) gebildet werden, mit
- einer ersten Schneid- oder Trenneinrichtung zum Ankerben der Trägerkarte (TK) entlang einer Kontur der in die Trägerkarte (TK) einzubringenden äußeren Teilkavität; (ÄTK)
- einer Vorrichtung zum Entfernen von Papiermaterial innerhalb der ersten Kontur zum Herstellen der in die Trägerkarte (TK) einzubringenden äußeren Teilkavität; (ÄTK) einer Vorrichtung zum Entfernen von Papiermaterial innerhalb einer zweiten Kontur der in die Trägerkarte (TK) einzubringenden inneren Teilkavität; (ITK)
- einer Vorrichtung zum Ausformen der heraustrennbaren integrierten Chip-modulkarte/n (CMK) im Mini-SIM -, Micro-SIM -, Nano-SIM -, und/oder Embedded-SIM - Format mit An- oder Durchkerbungen (AK) und/oder Stegen (St) zwischen jeder heraustrennbaren integrierten Chipmodulkarte/n (CMK) und der übrigen Trägerkarte; (TK) und
- einer Vorrichtung zum Einkleben eines integrierten Chipmoduls (ChM) in die Kavität.

12. Vorrichtung zum Herstellen einer Trägerkarte (TK) mit heraustrennbarer integrierter Chipmodulkarte (CMK) nach dem vorhergehenden Anspruch, mit
- einer oder zwei Fräseinrichtungen, um das Papiermaterial durch erstes und/ oder zweites Fräsen innerhalb der ersten und / oder innerhalb der zweiten Kontur zu entfernen, und/oder wobei
- eine zweite Schneid- oder Trenneinrichtung zum Ankerben vorgesehen ist, um die Trägerkarte (TK) entlang der zweiten Kontur der in die Trägerkarte (TK) einzubringenden inneren Teilkavität (ITK) anzukerben.

13. vorrichtung zum Herstellen einer Trägerkarte (TK) mit heraustrennbarer integrierter Chipmodulkarte (CMK) nach einem der vorhergehenden Ansprüche, die dazu eingerichtet ist, eine Trägerkarte (TK) aus einem mehrlagigen Papier zu verarbeiten, bei der die einzelnen Papierlagen (PL1, PL2, PL3) im Bereich der herzustellenden Kavität nicht verklebt sind, und/oder mit einem Sauger zum Entfernen von Papiermaterial durch erstes Heraussaugen des Papiermaterials innerhalb der ersten Kontur, und / oder einen Sauger zum Entfernen von Papiermaterial durch zweites Heraussaugen des Papiermaterials innerhalb der zweiten Kontur.

14. Vorrichtung zum Herstellen einer Trägerkarte (TK) mit heraustrennbarer integrierter Chipmodulkarte (CMK) nach einem der vorhergehenden Ansprüche, wobei
- die erste und/oder zweite Schneid- oder Trenneinrichtung zum Ankerben dazu eingerichtet ist, die Trägerkarte (TK) jeweils auf eine Tiefe anzukerben, die mindestens der Tiefe der jeweiligen äußeren oder inneren Teilkavität (ITK) entsprechen, und/oder wobei
- die erste und/oder zweite Schneid- oder Trenneinrichtung zum Ankerben dazu eingerichtet ist, die Trägerkarte (TK) jeweils auf eine Tiefe von etwa 200 - 300 Mikrometer anzukerben, und/oder wobei die erste und/oder zweite Schneid- oder Trenneinrichtung zum Ankerben dazu eingerichtet ist, eine Tiefe anzukerben, die der Dicke der jeweils gekerbten Papierlage oder eines Teils davon entspricht, und/oder wobei
- die Fräseinrichtung/en dazu eingerichtet ist/sind, bei einer mehrlagigen Karte jeweils auf eine Tiefe auszufräsen, die der Dicke der jeweils auszufräsenden Papierlage oder eines Teils davon entspricht, und/oder wobei
- die Vorrichtung zum Einkleben eines integrierten Chipmoduls (ChM) in die Kavität
dazu eingerichtet ist, das integrierte Chipmoduls (ChM) am Übergang zwischen der inneren und der äußeren Kavität anzukleben, bevor oder nachdem die heraustrennbare integrierte Chipmodulkarte (ChM) aus der übrigen Trägerkarte (TK) ausgeformt wird.

15. Chipmodulkarte, (CMK) erhältlich mit der Vorrichtung nach einem der Ansprüche 11 bis 14 und/oder nach dem Verfahren eines oder mehrerer der Ansprüche 1 bis 10, wobei als Papier ein zellulosehaltiges Material mit folgenden Eigenschaften verwendet wird:
| **Größe** | **Prüfvorschrift** | **Einheit** | **Wert** |
|---|---|---|---|
| Flächenbezogene Masse | DIN EN ISO 536 | g/m² | 10 - 800 |
| Dicke | DIN EN ISO 534 | µm | 10 - 800 |
| Biegesteifigkeit | DIN EN ISO 5629 | mNm | |
| Resonanz mNm | | | |
| MD | | | 200 - 300 z.B. |
| CD | | | 309 |
| | | | 120 - 200 z.B. |
| | | | 167 |
| Rauigkeit | DIN EN ISO 8791-4 | PPS, µm | 0,8 - 1, 2 z.B. |
| | | | 1,0 |
| CIE-Weißegrad (D65/10°) | DIN EN ISO 11 475 | | 124 |
| Gefügefestigkeit (Scott bond) | Tappi 569 | J/m² | 100 - 300, z.B. |
| | | | 200 |

16. Chipmodulkarte (CMK) mit einer mehrlagigen Karte erhältlich mit der Vorrichtung nach einem der Ansprüche 11 bis 14 und/oder nach dem Verfahren gemäß einem der Ansprüche 1 bis 10, bei der für die einzelnen Lagen die Papiere unterschiedliche oder gleiche Dicke haben.

17. Chipmodulkarte (CMK) mit einer mehrlagigen Karte nach Anspruch 16, die aus einer Trägerkarte (TK) heraustrennbar ist, wobei ein Chipmodul (ChM) in einer Kavität mit einer äußeren (ÄTK) und einer inneren Teilkavität (ITK) aufgenommen ist, wobei die äußere (ÄTK) Teilkavität und / oder die innere Teilkavität (ITK) jeweils eine zum Grund der Kavität hin sich verjüngende kegelstumpfförmige äußere Mantelfläche bzw. innere Mantelfläche mit einem Kegelwinkel zwischen 12 Grad und etwa 20 Grad haben.

## Claims

1. Method for producing a carrier card (TK) with detachable integrated chip-module card (CMK) with the following steps:
- providing a carrier card (TK) in the ID-1 format consisting of a single-layer or multilayer paper, wherein the individual layers (PL1, PL2, PL3) exhibit predetermined material properties,
and the individual layers have been connected with water-resistant adhesive,
- a- producing a cavity, the cavity having one or more stages, so that at least an outer (ÄTK) and an inner (ITK) partial cavity are formed, by
- a1- first notching of the carrier card (TK) along a contour of the outer partial cavity (ÄTK) to be introduced into the carrier card (TK);
- a2- removing paper material within the first contour for the purpose of producing the outer partial cavity (ÄTK) to be introduced into the carrier card (TK);
- a4- removing paper material within a second contour of the inner partial cavity (ITK) to be introduced into the carrier card (TK);
- b- shaping the detachable integrated chip-module card(s) (CMK) in the mini-SIM, micro-SIM, nano-SIM and/or embedded-SIM format with notches or through-notches (AK) and/or ridges (St) between each detachable integrated chip-module card (CMK) and the rest of the carrier card (TK); and
- c- gluing an integrated chip module (ChM) into the cavity.

2. Method for producing a carrier card (TK) with detachable integrated chip-module card (CMK) according to the preceding claim, wherein the steps:
removing paper material by first milling within the first contour, and/or by second milling within the second contour are undertaken, and/or wherein prior to step -a4- and step -a3-, second notching of the carrier card (TK) along the second contour of the inner partial cavity (ITK) to be introduced into the carrier card (TK),
is undertaken, and/or wherein
the provision of a carrier card (TK) consisting of a multilayer paper includes the condition that the individual layers of paper in the region of the cavity to be produced have not been bonded.

3. Method for producing a carrier card (TK) with detachable integrated chip-module card (CMK) according to the preceding claim, wherein steps:
- a1- and -a4-, removal of paper material by
first extraction by suction of the paper material within the first contour, and/or by
second extraction by suction of the paper material within the second contour, are undertaken.

4. Method for producing a carrier card (TK) with detachable integrated chip-module card (CMK) according to Claim 1, wherein
- the first and/or the second notching are each undertaken to a depth that corresponds at least to the depth of the respective outer or inner partial cavity (ITK), and/or wherein
- the notching is undertaken in each instance to a depth of about 200 - 300 microns, and/or wherein
- the milling is undertaken in each instance to a depth of about 200 - 300 microns, and/or wherein
- in the case of a multilayer card the notching is undertaken in each instance to a depth that corresponds to the thickness of the respectively notched layer of paper, and/or wherein
- in the case of a multilayer card the milling is undertaken in each instance to a depth that corresponds to the thickness of the respectively notched layer(s) of paper.

5. Method for producing a carrier card (TK) with detachable integrated chip-module card (CMK) according to one of the preceding claims, wherein step -c-, gluing an integrated chip module (ChM) into the cavity, is executed before or after step -b-, shaping the detachable integrated chip-module card(s) (CMK) between each of the detachable integrated chip-module cards (CMK) and the remaining carrier card (TK).

6. Method for producing a carrier card (TK) with detachable integrated chip-module card (CMK) according to one of the preceding claims, wherein a cellulosic material with the following properties is used as paper:
| **Quantity** | **Test Specification** | **Unit** | **Value** |
|---|---|---|---|
| Grammage | DIN EN ISO 536 | g/m² | 10 - 800 |
| Thickness | DIN EN ISO 534 | µm | 10 - 800 |
| Flexural Stiffness | DIN EN ISO 5629 | mNm | |
| Resonance mNm | | | |
| MD | | | 200 - 300, e.g. |
| CD | | | 309 |
| | | | 120 - 200, e.g. |
| | | | 167 |
| Roughness | DIN EN ISO 8791-4 | PPS, µm | 0.8 - 1.2, e.g. |
| | | | 1.0 |
| CIE Whiteness (D65/10°) | DIN EN ISO 11 475 | | 124 |
| Structural Strength (Scott bond) | Tappi 569 | J/m² | 100 - 300, e.g. |
| | | | 200 |

7. Method for producing a carrier card (TK) with detachable integrated chip-module card (CMK) according to one of the preceding claims, wherein papers with varying or equal thickness are used for the individual layers (PL1, PL2, PL3) in the case of a multilayer card.

8. Method for producing a carrier card (TK) with detachable integrated chip-module card (CMK) according to one of the preceding claims, wherein step - a4- is undertaken prior to step -a2-, and/or step -a4- is undertaken prior to step -a1-, and/or wherein
steps -a-, -b- and -c- are executed
in the order -a-, then -b-, and then -c-, or
in the order -a-, then -c-, and then -b-, or
in the order -b-, then -a-, and then -c-
and/or wherein steps
-a1-, -a2-, optionally -a3-, and -a4- are executed
in the order -a1-, then -a2-, optionally then -a3-, and then -a4-, or
in the order -a1-, optionally then -a3-, then -a2-, and then -a4-.

9. Method for producing a carrier card (TK) with detachable integrated chip-module card (CMK) according to one of the preceding claims, wherein steps -a1- and optionally -a3- are executed with the following notching parameters: 5 - 15 degrees outwards and 25 - 35 degrees inwards.

10. Method for producing a carrier card (TK) with detachable integrated chip-module card (CMK) according to one of the preceding claims, wherein steps -a2- and -a4-, removing paper material within the first and the second contour for the purpose of producing the outer (ÄTK) and inner (ITK) partial cavity to be introduced into the carrier card (TK), are executed in such a way that the outer partial cavity (ÄTK) and the inner partial cavity (ITK) respectively have a frustoconical outer circumferential surface and inner circumferential surface tapering towards the bottom of the cavity with a cone angle between 12 degrees and about 20 degrees.

11. Apparatus for producing a carrier card (TK) with detachable integrated chip-module card (CMK), with
- a module for providing a carrier card (TK) in the ID-1 format consisting of a single-layer or multilayer paper, wherein the individual layers (PL1, PL2, PL3) exhibit predetermined material properties and the individual layers (PL1, PL2, PL3) have been connected with water-resistant adhesive,
- an apparatus for producing a cavity, the cavity having one or more stages so that at least an outer (ÄTK) and an inner (ITK) partial cavity are formed, with
- a first cutting device or separating device for notching the carrier card (TK) along a contour of the outer partial cavity (ÄTK) to be introduced into the carrier card (TK);
- an apparatus for removing paper material within the first contour for the purpose of producing the outer partial cavity (ÄTK) to be introduced into the carrier card (TK);
- an apparatus for removing paper material within a second contour of the inner partial cavity (ITK) to be introduced into the carrier card (TK);
- an apparatus for shaping the detachable integrated chip-module card(s) (CMK) in the mini-SIM, micro-SIM, nano-SIM and/or embedded-SIM format with notches or through-notches (AK) and/or ridges (St) between each detachable integrated chip-module card (CMK) and the rest of the carrier card (TK); and
- an apparatus for gluing an integrated chip module (ChM) into the cavity.

12. Apparatus for producing a carrier card (TK) with detachable integrated chip-module card (CMK) according to the preceding claim, with
- one or two milling devices, in order to remove the paper material by first and/or second milling within the first and/or within the second contour, and/or wherein
- a second cutting device or separating device for notching has been provided, in order to notch the carrier card (TK) along the second contour of the inner partial cavity (ITK) to be introduced into the carrier card (TK).

13. Apparatus for producing a carrier card (TK) with detachable integrated chip-module card (CMK) according to one of the preceding claims, which has been set up to process a carrier card (TK), consisting of a multilayer paper, in which the individual layers (PL1, PL2, PL3) of paper have not been bonded in the region of the cavity to be produced, and/or
with a suction box for removing paper material by first extraction by suction of the paper material within the first contour, and/or with a suction box for removing paper material by second extraction by suction of the paper material within the second contour.

14. Apparatus for producing a carrier card (TK) with detachable integrated chip-module card (CMK) according to one of the preceding claims, wherein
- the first and/or second cutting device or separating device for notching has/have been set up to notch the carrier card (TK) in each instance to a depth that corresponds at least to the depth of the respective outer (ÄTK) or inner (ITK) partial cavity, and/or wherein
- the first and/or second cutting device or separating device for notching has/have been set up to notch the carrier card (TK) in each instance to a depth of about 200 - 300 microns, and/or wherein the first and/or second cutting device or separating device for notching has/have been set up to notch a depth that corresponds to the thickness of the respectively notched layer of paper or of a part thereof, and/or wherein
- the milling device(s) has/have been set up to mill out, in the case of a multilayer card, in each instance to a depth that corresponds to the thickness of the layer of paper respectively to be milled out or of a part thereof, and/or wherein
- the device for gluing an integrated chip module (ChM) into the cavity has been set up to glue on the integrated chip module (ChM) at the transition between the inner and the outer cavity before or after the detachable integrated chip-module card (CMK) is shaped out of the rest of the carrier card (TK).

15. Chip-module card (CMK), obtainable with the apparatus according to one of Claims 11 to 14 and/or by the method of one or more of Claims 1 to 10, wherein a cellulosic material with the following properties is used as paper:
| **Quantity** | **Test Specification** | **Unit** | **Value** |
|---|---|---|---|
| Grammage | DIN EN ISO 536 | g/m² | 10 - 800 |
| Thickness | DIN EN ISO 534 | µm | 10 - 800 |
| Flexural Stiffness | DIN EN ISO 5629 | mNm | |
| Resonance mNm | | | |
| MD | | | 200 - 300, e.g. |
| CD | | | 309 |
| | | | 120 - 200, e.g. |
| | | | 167 |
| Roughness | DIN EN ISO 8791-4 | PPS, µm | 0.8 - 1.2, e.g. |
| | | | 1.0 |
| CIE Whiteness (D65/10°) | DIN EN ISO 11 475 | | 124 |
| Structural Strength (Scott bond) | Tappi 569 | J/m² | 100 - 300, e.g. |
| | | | 200 |

16. Chip-module card (CMK) with a multilayer card obtainable with the apparatus according to one of Claims 11 to 14 and/or by the method according to one of Claims 1 to 10, in which the papers for the individual layers have varying or equal thickness.

17. Chip-module card (CMK) with a multilayer card according to Claim 16 that is detachable from a carrier card (TK), wherein a chip module (ChM) has been received in a cavity with an outer (ÄTK) and an inner (ITK) partial cavity, wherein the outer partial cavity (ÄTK) and/or the inner partial cavity (ITK) respectively have a frustoconical outer circumferential surface and inner circumferential surface tapering towards the bottom of the cavity with a cone angle between 12 degrees and about 20 degrees.

## Revendications

1. Procédé de fabrication d'une carte support (TK) équipée d'une carte à module à puce intégré (CMK) séparable, comprenant les étapes suivantes :
- mise à disposition d'une carte support (TK) au format ID1 constituée d'un papier mono- ou multicouche, les différentes couches (PL1, PL2, PL3) possédant des propriétés de matériau prédéfinies, et les différentes couches étant assemblées au moyen d'un adhésif résistant à l'eau,
- a- réalisation d'une cavité, laquelle cavité étant à un ou plusieurs étages, de façon à former au moins une cavité partielle extérieure (ÄTK) et une cavité partielle intérieure (ITK), par
- a1- un premier entaillage de la carte support (TK) le long d'un contour de la cavité partielle extérieure (ÄTK) à ménager dans la carte support (TK) ;
- a2- enlèvement de matériau papier à l'intérieur du premier contour pour réaliser la cavité partielle extérieure (ÄTK) à ménager dans la carte support (TK) ;
- a4- enlèvement de matériau papier à l'intérieur d'un deuxième contour de la cavité partielle intérieure (ITK) à ménager dans la carte support (TK) ;
- b- formage de la ou des carte(s) à module à puce intégré (CMK) séparable(s) au format Mini-SIM, Micro-SIM, Nano-SIM et/ou Embedded-SIM en réalisant des entailles ou des crevés (AK) et/ou des ponts (St) entre chaque carte à module à puce intégré (CMK) séparable et le reste de la carte support (TK) ; et
- c- collage d'un module à puce intégré (ChM) dans la cavité.

2. Procédé de fabrication d'une carte support (TK) équipée d'une carte à module à puce intégré (CMK) séparable selon la revendication précédente, dans lequel les étapes :
enlèvement de matériau papier sont effectuées par un premier fraisage à l'intérieur du premier contour et/ou par un deuxième fraisage à l'intérieur du deuxième contour, et/ou dans lequel une étape -a3- deuxième entaillage de la carte support (TK) le long du deuxième contour de la cavité partielle intérieure (ITK) à ménager dans la carte support (TK) est effectuée avant l'étape -a4-, et/ou dans lequel la mise à disposition d'une carte support (TK) constituée d'un papier multicouche comprend le fait que les différentes couches de papier ne sont pas collées dans la zone de la cavité à réaliser.

3. Procédé de fabrication d'une carte support (TK) équipée d'une carte à module à puce intégré (CMK) séparable selon la revendication précédente, dans lequel les étapes :
- a1- et -a4- enlèvement de matériau papier sont effectuées par une première aspiration du matériau papier à l'intérieur du premier contour et/ou par une deuxième aspiration du matériau papier à l'intérieur du deuxième contour.

4. Procédé de fabrication d'une carte support (TK) équipée d'une carte à module à puce intégré (CMK) séparable selon la revendication 1, dans lequel
- le premier et/ou le deuxième entaillage sont effectués respectivement à une profondeur qui correspond au moins à la profondeur de la cavité partielle extérieure ou intérieure (ITK) respective, et/ou dans lequel
- l'entaillage est effectué respectivement à une profondeur d'environ 200 à 300 micromètres, et/ou dans lequel
- le fraisage est effectué respectivement à une profondeur d'environ 200 à 300 micromètres, et/ou dans lequel
- dans le cas d'une carte multicouche, l'entaillage est effectué respectivement à une profondeur qui correspond à l'épaisseur de la couche de papier respectivement entaillée, et/ou dans lequel
- dans le cas d'une carte multicouche, le fraisage est effectué respectivement à une profondeur qui correspond à l'épaisseur de la ou des couche(s) de papier respectivement entaillée(s).

5. Procédé de fabrication d'une carte support (TK) équipée d'une carte à module à puce intégré (CMK) séparable selon l'une des revendications précédentes, dans lequel l'étape -c- collage d'un module à puce intégré (ChM) dans la cavité est réalisée avant ou après l'étape -b- formage de la ou des carte(s) à module à puce intégré (CMK) séparable(s) entre la ou chacune des carte(s) à module à puce intégré (CMK) séparable(s) et le reste de la carte support (TK).

6. Procédé de fabrication d'une carte support (TK) équipée d'une carte à module à puce intégré (CMK) séparable selon l'une des revendications précédentes, dans lequel on utilise comme papier un matériau cellulosique possédant les propriétés suivantes :
| **Grandeur** | **Prescription d'essai** | **Unité** | **Valeur** |
|---|---|---|---|
| Masse surfacique | DIN EN ISO 536 | g/m² | 10 - 800 |
| Epaisseur | DIN EN ISO 534 | µm | 10 - 800 |
| Raideur à la flexion | DIN EN ISO 5629 | mNm | |
| Résonance mNm | | | |
| MD | | | 200 - 300 p. ex. |
| CD | | | 309 |
| | | | 120 - 200 p. ex. |
| | | | 167 |
| Rugosité | DIN EN ISO 8791-4 | PPS, µm | 0,8 - 1,2 p. ex. |
| | | | 1,0 |
| Degré de blancheur CIE (D65/10°) | DIN EN ISO 11 475 | | 124 |
| Cohésion interne (Scott bond) | Tappi 569 | J/m² | 100 - 300, p. ex. |
| | | | 200 |

7. Procédé de fabrication d'une carte support (TK) équipée d'une carte à module à puce intégré (CMK) séparable selon l'une des revendications précédentes, dans lequel, dans le cas d'une carte multicouche, on utilise des papiers (PL1, PL2, PL3) d'épaisseur différente ou de même épaisseur pour les différentes couches.

8. Procédé de fabrication d'une carte support (TK) équipée d'une carte à module à puce intégré (CMK) séparable selon l'une des revendications précédentes, dans lequel l'étape -a4- est effectuée avant l'étape -a2- et/ou l'étape -a4- est effectuée avant l'étape -a1-, et/ou dans lequel
les étapes -a-, -b- et -c- sont réalisées
dans l'ordre -a-, puis -b-, et puis -c-, ou
dans l'ordre -a-, puis -c-, et puis -b-, ou
dans l'ordre -b-, puis -a-, et puis -c-,
et/ou dans lequel les étapes
-a1-, -a2-, le cas échéant -a3-, et -a4- sont réalisées
dans l'ordre -a1-, puis -a2-, puis le cas échéant -a3-, et puis -a4-, ou
dans l'ordre -a1-, puis le cas échéant -a3-, puis -a2-, et puis -a4-.

9. Procédé de fabrication d'une carte support (TK) équipée d'une carte à module à puce intégré (CMK) séparable selon l'une des revendications précédentes, dans lequel les étapes
- a1- et le cas échéant -a3- sont réalisées avec les paramètres d'entaille suivants :
5 à 15 degrés vers l'extérieur et 25 à 35 degrés vers l'intérieur.

10. Procédé de fabrication d'une carte support (TK) équipée d'une carte à module à puce intégré (CMK) séparable selon l'une des revendications précédentes, dans lequel les étapes
- a2- et -a4- enlèvement de matériau papier à l'intérieur du premier, respectivement du deuxième contour pour réaliser la cavité partielle extérieure (ÄTK), respectivement intérieure (ITK) à ménager dans la carte support (TK) sont réalisées de telle façon que la cavité partielle extérieure (ÄTK) et la cavité partielle intérieure (ITK) aient une surface périphérique extérieure, respectivement une surface périphérique intérieure se rétrécissant en forme tronconique en direction du fond de la cavité, d'un angle de cône compris entre 12 degrés et environ 20 degrés.

11. Dispositif de fabrication d'une carte support (TK) équipée d'une carte à module à puce intégré (CMK) séparable, comprenant :
- un module pour mettre à disposition une carte support (TK) au format ID1 constituée d'un papier mono- ou multicouche, les différentes couches (PL1, PL2, PL3) possédant des propriétés de matériau prédéfinies et les différentes couches étant assemblées au moyen d'un adhésif résistant à l'eau,
- un dispositif pour réaliser une cavité, laquelle cavité étant à un ou plusieurs étages, de façon à former au moins une cavité partielle extérieure (ÄTK) et une cavité partielle intérieure (ITK), comprenant
- un premier moyen de coupe ou de découpe pour entailler la carte support (TK) le long d'un contour de la cavité partielle extérieure (ÄTK) à ménager dans la carte support (TK) ;
- un dispositif pour enlever du matériau papier à l'intérieur du premier contour pour réaliser la cavité partielle extérieure (ÄTK) à ménager dans la carte support (TK) ;
- un dispositif pour enlever du matériau papier à l'intérieur d'un deuxième contour de la cavité partielle intérieure (ITK) à ménager dans la carte support (TK) ;
- un dispositif pour former la ou les carte(s) à module à puce intégré (CMK) séparable(s) au format Mini-SIM, Micro-SIM, Nano-SIM et/ou Embedded-SIM en réalisant des entailles ou des crevés (AK) et/ou des ponts (St) entre chaque carte à module à puce intégré (CMK) séparable et le reste de la carte support (TK) ; et
- un dispositif pour coller un module à puce intégré (ChM) dans la cavité.

12. Dispositif de fabrication d'une carte support (TK) équipée d'une carte à module à puce intégré (CMK) séparable selon la revendication précédente, comprenant
- un ou deux moyens de fraisage pour enlever le matériau papier par un premier et/ou un deuxième fraisage à l'intérieur du premier et/ou à l'intérieur du deuxième contour, et/ou dans lequel
- un deuxième moyen de coupe ou de découpe pour l'entaillage est prévu pour entailler la carte support (TK) le long du deuxième contour de la cavité partielle intérieure (ITK) à ménager dans la carte support (TK).

13. Dispositif de fabrication d'une carte support (TK) équipée d'une carte à module à puce intégré (CMK) séparable selon l'une des revendications précédentes, qui est conçu pour traiter une carte support (TK) constituée d'un papier multicouche, dans laquelle les différentes couches de papier ne sont pas collées dans la zone de la cavité à réaliser, et/ou
comprenant un aspirateur pour enlever du matériau papier par une première aspiration du matériau papier à l'intérieur du premier contour et/ou un aspirateur pour enlever du matériau papier par une deuxième aspiration du matériau papier à l'intérieur du deuxième contour.

14. Dispositif de fabrication d'une carte support (TK) équipée d'une carte à module à puce intégré (CMK) séparable selon l'une des revendications précédentes, dans lequel
- le premier et/ou deuxième moyen de coupe ou de découpe pour l'entaillage est conçu pour entailler la carte support (TK) respectivement à une profondeur qui correspond au moins à la profondeur de la cavité partielle extérieure ou intérieure (ITK) respective, et/ou dans lequel
- le premier et/ou deuxième moyen de coupe ou de découpe pour l'entaillage est conçu pour entailler la carte support (TK) respectivement à une profondeur d'environ 200 à 300 micromètres, et/ou dans lequel le premier et/ou deuxième moyen de coupe ou de découpe pour l'entaillage est conçu pour entailler à une profondeur qui correspond à l'épaisseur de la couche de papier respectivement entaillée ou à une partie de celle-ci, et/ou dans lequel
- le(s) moyen(s) de fraisage est/sont conçu(s), dans le cas d'une carte multicouche, pour fraiser respectivement à une profondeur qui correspond à l'épaisseur de la couche de papier respectivement à fraiser ou à une partie de celle-ci, et/ou dans lequel
- le dispositif pour coller un module à puce intégré (ChM) dans la cavité est conçu pour coller le module à puce intégré (ChM) à la transition entre la cavité intérieure et la cavité extérieure, avant ou après que le module à puce intégré (ChM) séparable soit formé dans le reste de la carte support (TK).

15. Carte à module à puce (CMK), pouvant être obtenue moyennant le dispositif selon l'une des revendications 11 à 14 et/ou selon le procédé selon l'une ou plusieurs des revendications 1 à 10, dans laquelle un matériau cellulosique possédant les propriétés suivantes est utilisé comme papier :
| **Grandeur** | **Prescription d'essai** | **Unité** | **Valeur** |
|---|---|---|---|
| Masse surfacique | DIN EN ISO 536 | g/m² | 10 - 800 |
| Epaisseur | DIN EN ISO 534 | µm | 10 - 800 |
| Raideur à la flexion | DIN EN ISO 5629 | mNm | |
| Résonance mNm | | | |
| MD | | | 200 - 300 p. ex. |
| CD | | | 309 |
| | | | 120 - 200 p. ex. |
| | | | 167 |
| Rugosité | DIN EN ISO 8791-4 | PPS, µm | 0,8 - 1,2 p. ex. |
| | | | 1,0 |
| Degré de blancheur CIE (D65/10°) | DIN EN ISO 11 475 | | 124 |
| Cohésion interne (Scott bond) | Tappi 569 | J/m² | 100 - 300, p. ex. |
| | | | 200 |

16. Carte à module à puce (CMK) comprenant une carte multicouche pouvant être obtenue moyennant le dispositif selon l'une des revendications 11 à 14 et/ou selon le procédé selon l'une des revendications 1 à 10, dans laquelle les papiers ont une épaisseur différente ou la même épaisseur pour les différentes couches.

17. Carte à module à puce (CMK) comprenant une carte multicouche selon la revendication 16, susceptible d'être séparée d'une carte support (TK), dans laquelle un module à puce (ChM) est reçu dans une cavité comprenant une cavité partielle extérieure (ÄTK) et une cavité partielle intérieure (ITK), la cavité partielle extérieure (ÄTK) et/ou la cavité partielle intérieure (ITK) ayant une surface périphérique extérieure, respectivement une surface périphérique intérieure, se rétrécissant en forme tronconique en direction du fond de la cavité, d'un angle de cône compris entre 12 degrés et environ 20 degrés.
